# FASCICULE DE BREVET EUROPEEN

(11) **EP 1 346 231 B1**
(45) Date de publication et mention de la délivrance du brevet: **23.11.2005**
(21) Numéro de dépôt: 01989670.3
(22) Date de dépôt: 27.12.2001
(51) Int. Cl.: G01R 1/00

(54) **PROCEDES ET APPAREILS POUR LE TRAITEMENT ANALOGIQUE DU SIGNAL EMIS PAR UN DETECTEUR DE PARTICULES**
VERFAHREN UND GERÄTE ZUR ANALOGEN VERARBEITUNG EINES VON EINEM TEILCHENDETEKTOR EMITTIERTEN SIGNALS
METHOD AND APPLIANCES FOR ANALOG PROCESSING OF A SIGNAL EMITTED BY A PARTICLE DETECTOR

(30) Priorité: 28.12.2000 FR 0017220
(43) Date de publication de la demande: 24.09.2003
(73) Titulaire: COMMISSARIAT A L'ENERGIE ATOMIQUE, 75015 Paris (FR)
(72) Inventeur: ARQUES, Marc, F-38100 Grenoble (FR)
(74) Mandataire: Santarelli
(86) Numéro de dépôt international: PCT/FR2001/004215
(87) Numéro de publication internationale: WO 2002/054087

(56) Documents cités:
- DE-C- 3 718 305
- US-A- 4 036 057
- US-A- 4 880 981
- US-A- 5 204 631
- US-A- 5 854 489
- BARNETT T G: "BUILD LOW-COST WINDOW COMPARATOR" ELECTRONIC DESIGN, PENTON PUBLISHING, CLEVELAND, OH, US, vol. 39, no. 13, 11 juillet 1991 (1991-07-11), pages 136-137, XP000364927 ISSN: 0013-4872

## Description

La présente invention concerne l'analyse d'un flux de particules reçu par un détecteur de particules pendant un intervalle donné, par exemple dans le but de compter ces particules ou de mesurer leur énergie. Elle concerne plus particulièrement des procédés d'analyse utilisant un traitement analogique du signal émis par ledit détecteur, ainsi que les dispositifs et appareils destinés à mettre en oeuvre ces procédés.

Les détecteurs considérés dans la présente invention sont des détecteurs connus, qu'ils soient de type ponctuel ou matriciel, et quelles que soient les matières, semi-conductrices ou autres, qui les composent. Les signaux émis par ces détecteurs peuvent être soit des courants électriques, soit d'une nature physique pouvant être convertie de manière connue en courant électrique. On supposera simplement que la réception d'une particule par le détecteur déclenche un signal de sortie ayant la forme d'une impulsion d'une certaine largeur et dont l'amplitude maximale est représentative de l'énergie de cette particule.

L'invention s'applique à tout domaine où l'analyse d'un flux de particules, et notamment leur comptage ou la mesure de leur énergie, peut être utile, par exemple, dans le cas où ces particules sont des photons, en radiologie, en fluoroscopie ou en imagerie vidéo. Elle est particulièrement adaptée aux domaines où l'on recherche un procédé de traitement du signal qui, bien qu'étant de haute qualité (au sens où ledit procédé permet des mesures très exactes du flux), utilise pour ce faire un dispositif peu encombrant ; c'est notamment le cas quand ce dispositif est composé non pas d'un détecteur (pixel) unique, mais d'une matrice de pixels, car la taille de l'électronique utilisée est alors limitée par le pas des pixels.

Dans la suite de la description, pour fixer les idées, on parlera de détection de « photons » (c'est à dire de la mesure de caractéristiques d'un rayonnement électromagnétique), mais on se rendra compte que l'invention est totalement indépendante de la nature des particules détectées.

Une cause importante de limitation de la qualité de traitement du signal est le bruit de fond qui est toujours présent dans le courant émis par le détecteur. Ce bruit de fond comprend au moins deux composantes. La première composante est le « courant d'obscurité », c'est-à-dire le courant fluctuant, d'origine thermique, émis par le détecteur, même quand il ne reçoit pas de photons. La seconde composante est le « courant de traînage », c'est-à-dire le courant fluctuant qui se manifeste pendant un certain temps après la réception d'un photon par le détecteur ; dans les détecteurs utilisant des matières semi-conductrices, ce courant de traînage est notamment dû aux défauts cristallins de ces matières.

Examinons les conséquences de ce bruit de fond sur l'exactitude des mesures effectuées au moyen des procédés connus.

Si par exemple on utilise un système de mesure fonctionnant en intégration, au moyen duquel on mesure l'énergie totale du rayonnement reçu par le détecteur pendant une durée prédéterminée, on intègre sur cette durée le courant issu du détecteur. Une représentation fidèle de l'énergie des photons reçus exige alors de prendre en considération tout le courant engendré, y compris les valeurs faibles : l'utilisation d'un seuil de détection de ce courant serait donc nuisible, car causant une perte d'information. Mais le courant mesuré comporte, comme expliqué ci-dessus, une composante due au bruit de fond, à laquelle on ne peut attribuer une valeur exacte en raison des fluctuations dues aux dérives thermiques et au traînage, et en raison du bruit statistique attaché à cette composante.

Le brevet US - 5,854,489 concerne un procédé et un dispositif pour le traitement du signal fourni par un détecteur à matériau semi-conducteur en réponse à l'interaction d'un photon gamma avec le matériau semi-conducteur. Selon ce document, on commence par amplifier ce signal et en éliminer par filtrage la composante continue, qui correspond à la valeur moyenne du bruit de fond. Puis on mesure une charge électrique qui est proportionnelle à l'amplitude maximale, soit de ce signal amplifié et filtré, soit de sa composante électronique (c'est-à-dire sans la composante due à la migration des trous). On mesure également le temps de montée de cette composante électronique. Des courbes de corrélation charge électrique - temps de montée sont établies.

Dans d'autres systèmes connus, on intègre le courant dû au bruit de fond dans la valeur mesurée, et l'on soustrait ensuite, pour obtenir la valeur représentative de l'énergie du rayonnement, une quantité qui n'est qu'une valeur moyenne estimée de l'effet du bruit de fond.

Comme autre exemple, quand on utilise un système de mesure fonctionnant en comptage, au moyen duquel on mesure le nombre de photons d'énergie E supérieure à un seuil *E*_{*2*} reçus par le détecteur pendant une durée prédéterminée, on déclenche un dispositif adéquat (par exemple une bascule électronique) lorsque le signal dépasse une certaine valeur de seuil correspondant à *E*₂, et l'on réarme ledit dispositif lorsque le signal retombe au-dessous de cette valeur de seuil. Rien n'empêche alors, il est vrai, de placer en sortie du détecteur un système de filtrage de la composante continue du bruit de fond. Mais le problème est qu'on ne peut distinguer une montée de courant due à l'arrivée d'un photon avec la montée de courant engendrée par une fluctuation du bruit de fond, sauf si l'on place ladite valeur de seuil suffisamment haut pour que les fluctuations ne puissent pratiquement jamais la franchir. En outre, dans ces systèmes de mesure classiques, les bascules électroniques ou les dispositifs analogues engendrent des couplages parasites. On ne peut donc en pratique placer ce seuil très bas.

L'invention a donc pour objet des procédés, et des dispositifs relativement compacts mettant en oeuvre ces procédés, destinés à diminuer la sensibilité des mesures de flux de particules, d'une part aux fluctuations du bruit de fond présentes dans les signaux émis par les détecteurs, et d'autre part aux perturbations causées par l'électronique de mesure.

Dans ce but, l'invention propose un procédé de traitement du signal produit par un détecteur de particules, ledit procédé étant remarquable en ce que
l'on détecte dans ledit signal les portions où le signal est supérieur à une valeur prédéterminée *V*₁,
l'on mesure la valeur maximale *V*ₘₐₓ atteinte par le signal dans chacune desdites portions, et
l'on associe à chacune desdites portions une quantité analogique *Q* qui, au moins sur une plage de valeurs prédéterminée Δ*V*₁ de ladite valeur maximale *V*ₘₐₓ, est une fonction croissante, par exemple linéairement, de (*V*ₘₐₓ - *V*₁).

En effet, l'invention exploite le fait que, dans les détecteurs classiques, le « pic » de chaque impulsion de courant causée par une particule incidente est proportionnel à l'énergie de cette particule, ou du moins représentatif de cette énergie (on suppose pour fixer les idées que ladite impulsion prend des valeurs positives : le lecteur transposera facilement les caractéristiques de l'invention au cas où l'on mesure des valeurs négatives). Le procédé selon l'invention ne prend alors en considération que ce pic (sous la forme de *V*ₘₐₓ), sans tenir compte de la partie montante et de la partie descendante de chaque impulsion, et encore moins de la valeur du signal entre les impulsions, de sorte que l'effet des fluctuations du bruit de fond n'est ressenti que pendant la courte durée de ces impulsions, au cours desquelles on effectue les mesures. Il en résulte une amélioration sensible de la qualité des mesures par rapport aux procédés classiques.

En ce qui concerne le choix pratique du seuil de détection *V*₁, il est clair que, pour que ce seuillage soit opérant, la valeur de *V*₁ doit généralement être choisie supérieure au niveau moyen du bruit de fond (ou doit être choisie positive si l'on filtre en sortie du détecteur la composante continue du bruit de fond). Cela étant, plus la valeur de *V*₁ est élevée, et plus on s'affranchit des fluctuations du bruit de fond. Mais la présence de ce seuil *V*₁ empêche la détection des photons dont l'énergie (le cas échéant) est inférieure à l'énergie *E*₁ associée à une impulsion de tension culminant à *V*₁ ; par conséquent, plus la valeur de *V*₁ sera élevée, et plus grande sera la bande d'énergie pour laquelle des photons d'énergie appartenant à cette bande ne pourront pas être détectés. La valeur de *V*₁ devra donc être choisie judicieusement, sur ces bases, en fonction de l'application considérée.

La variation selon l'invention de la quantité analogique *Q* sur la plage de valeurs ΔV₁ permet naturellement de prendre en compte les variations d'énergie des photons reçus, et cela d'une manière qui peut être différente d'une application à l'autre de l'invention. Par exemple, en photométrie, on pourra préférer un comportement linéaire de la quantité analogique *Q* en fonction de l'énergie *E* du photon. Pour le comptage de photons, la fonction croissante (mais pas nécessairement linéaire) *Q*(*E*) permet de mettre en place un « seuillage progressif » autour d'une énergie prédéterminée, comme expliqué plus bas.

Selon des caractéristiques particulières de l'invention, on associe à chacune desdites portions une quantité analogique *Q* qui
est une fonction croissante, par exemple linéaire, de (*V*ₘₐₓ - *V*₁) si la valeur maximale *V*ₘₐₓ est inférieure à une deuxième valeur prédéterminée *V*₂, et
reste constante à sa valeur pour *V*ₘₐₓ = *V*₂ si la valeur maximale *V*ₘₐₓ est supérieure à cette deuxième valeur *V*₂, au moins sur une plage de valeurs prédéterminée Δ*V*₂ de ladite valeur maximale *V*ₘₐₓ.

Ces caractéristiques particulières sont très avantageuses quand on applique l'invention au comptage de photons, qui consiste, on le rappelle, à mesurer le nombre de photons d'énergie *E* supérieure à un seuil *E*₂ reçus par le détecteur pendant une durée prédéterminée. En effet, l'on associera alors à tout photon d'énergie *E* comprise entre *E*₁ et *E*₂ une quantité analogique *Q* proportionnelle à (*E* - *E*₁), et l'on associera à tout photon d'énergie *E* supérieure à *E*₂ une quantité analogique *Q*₂ proportionnelle à (*E*₂ - *E*₁). On met en place de la sorte un seuillage progressif autour de *E* = *E*₂.

Il peut être noté que ce seuillage progressif a comme avantage, par rapport à un seuillage très brutal, de permettre de tenir compte de pics dont l'énergie réelle est minimisée par un niveau instantané particulièrement bas du bruit de fond : en effet, la probabilité pour qu'une particule dont l'énergie apparente (telle que détectée) est inférieure au seuil de comptage que l'on s'est fixé ait tout de même une énergie réelle supérieure à ce seuil est d'autant plus forte que l'écart entre cette énergie apparente et ce seuil de comptage est faible. Ce seuillage progressif peut donc être compris comme l'application à l'énergie apparente des pics observés d'un coefficient de vraisemblance d'autant plus proche de 1 que cette énergie apparente est proche de *E*₂. En réalité le seuil de comptage (au dessus duquel on veut caractériser les particules) est inférieur à *E*₂ (mais il n'est pas nécessaire de le connaître) dans la mesure où il peut y avoir aussi des pics d'énergie apparente supérieure à leur énergie réelle en raison d'un niveau instantané particulièrement haut du bruit de fond : selon cette approche, *E*₂ est le niveau d'énergie pour lequel on estime pouvoir être sûr qu'il s'agit bien, indépendamment de la valeur instantanée du bruit de fond, d'une particule ayant une énergie réelle au moins égale au seuil de comptage précité.

Ce seuillage progressif permet en outre de tenir compte de ce que, dans l'analyse d'un phénomène physique, la transition en énergie entre les particules significatives et celles qui ne le sont pas n'est pas nécessairement brutale, les particules d'énergie proche du seuil pouvant contribuer au phénomène que l'on cherche à caractériser ; le seuillage progressif peut alors s'analyser comme l'affectation d'un coefficient d'efficacité des pics d'autant plus proche de 1 que le niveau d'énergie est proche de *E*₂.

Ces deux approches peuvent bien sûr se combiner, et le choix des seuils et de la pente de la portion croissante permet de tenir compte au mieux de ce que l'on veut caractériser ; ce choix peut se faire par exemple suite à des tests effectués dans des conditions précisément connues. Il faut bien comprendre ici que la forme linéaire d'une telle courbe croissante est particulièrement pratique, notamment en raison du faible nombre de coefficients à choisir, mais que d'autres formes sont possibles, pour tenir compte au mieux des résultats que l'on attend du seuillage progressif

Ce seuillage progressif permet de disposer le niveau au-dessus duquel on mesure le signal très près du niveau du bruit de fond : en effet, on applique aux pics faibles un coefficient de vraisemblance faible mais non nul tenant compte de la probabilité de ce que ce pic faible soit représentatif non pas d'une fluctuation du bruit de fond mais d'une particule dont on souhaite tenir compte.

On voit donc que, par rapport aux procédés classiques, l'invention permet avantageusement de compter des photons avec une grande exactitude même quand l'énergie *E*₂ est très basse. Un avantage supplémentaire est l'absence de signaux parasites du type de ceux engendrés, dans les compteurs classiques à bascule, par les commutations de cette bascule associées à l'incrémentation du compteur.

Selon des caractéristiques encore plus particulières de l'invention, on associe à chacune desdites portions une quantité analogique Q qui
est une fonction croissante de (*V*ₘₐₓ - *V*₁) si la valeur maximale *V*ₘₐₓ est inférieure à une deuxième valeur prédéterminée *V*₂,
reste constante à sa valeur pour *V*ₘₐₓ = *V*₂ si la valeur maximale *V*ₘₐₓ est comprise entre cette deuxième valeur *V*₂ et une troisième valeur prédéterminée *V*₃, et
est une fonction décroissante de *V*ₘₐₓ si la valeur maximale *V*ₘₐₓ est supérieure à cette troisième valeur *V*₃, au moins sur une plage de valeurs prédéterminée Δ*V*₃ de ladite valeur maximale *V*ₘₐₓ.

Grâce à ces dispositions, on pourra obtenir notamment une fonction *Q*(*E*) en forme de dent, ou bien approchant une Gaussienne. On pourra ainsi privilégier, dans le rayonnement reçu, les photons appartenant à une bande relativement étroite d'énergie, ces photons étant particulièrement significatifs dans le cadre de l'application envisagée.

Selon un autre aspect, l'invention concerne divers dispositifs.

Elle concerne ainsi, premièrement, un dispositif de traitement du signal produit par un détecteur de particules, ledit dispositif comprenant
- une unité de conversion capable de transformer toute impulsion de courant issue dudit détecteur en une impulsion de tension *V*,
- un circuit analogique comportant
   un réservoir de charges électriques D₃,
   un premier récepteur de charges électriques D₁ pouvant être alimenté par ledit réservoir de charges D₃ de manière commandable au moyen de ladite tension *V*, et
   un second récepteur de charges électriques D₂ pouvant lui aussi être alimenté par ledit réservoir de charges D₃ de manière commandable au moyen de ladite tension *V*, et
- un appareil de mesure de la charge électrique *Q* contenue dans ledit second récepteur de charges D₂,
ledit circuit analogique étant conçu de manière à ce que chaque impulsion de tension V produise successivement au sein dudit dispositif les effets suivants :
ledit réservoir de charges D₃ est isolé dudit premier récepteur de charges D₁,
le réservoir de charges D₃ est connecté audit second récepteur de charges D₂ quand la tension *V* dépasse une valeur prédéterminée *V*₁,
il passe de D₃ à D₂ une charge électrique *Q* qui est une fonction croissante de (*V* - *V*₁),
la connexion entre D₃ et D₂ est coupée quand la tension *V* commence à décroître après avoir atteint une valeur maximale *V*ₘₐₓ, et
D₃ est reconnecté à D₁ qui restaure dans D₃ la charge *Q* perdue.

L'invention concerne aussi, deuxièmement, un dispositif de traitement du signal produit par un détecteur de particules, ledit dispositif comprenant
- une unité de conversion capable de transformer toute impulsion de courant issue dudit détecteur en une impulsion de tension *V*,
- un circuit analogique comportant
   un réservoir de charges M₂,
   un premier récepteur de charges électriques D₁ pouvant être alimenté par ledit réservoir de charges M₂ de manière commandable au moyen de ladite tension *V*, et
   un second récepteur de charges électriques D₂ pouvant lui aussi être alimenté par ledit réservoir de charges M₂ de manière commandable au moyen de ladite tension *V*, et
- un appareil de mesure de la charge électrique *Q* contenue dans ledit second récepteur de charges D₂,
ledit circuit analogique étant conçu de manière à ce que chaque impulsion de tension *V* produise successivement au sein dudit dispositif les effets suivants :
ledit réservoir de charges M₂ est isolé dudit premier récepteur de charges D₁,
le réservoir de charges M₂ est connecté audit second récepteur de charges D₂ quand la tension *V* dépasse une première valeur prédéterminée *V*₁,
il passe de M₂ à D₂ une charge électrique *Q* proportionnelle à (*V*- *V*₁) si la tension *V* ne dépasse pas une deuxième valeur prédéterminée *V*₂, ou proportionnelle à (*V*₂ - *V*₁) si la tension *V* dépasse ladite deuxième valeur *V*₂,
la connexion entre M₂ et D₂ est coupée quand la tension *V* commence à décroître après avoir atteint une valeur maximale *V*ₘₐₓ, et
M₂ est reconnecté à D₁ qui restaure dans M₂ la charge *Q* perdue.

L'invention concerne aussi, troisièmement, un dispositif de traitement du signal produit par un détecteur de particules, ledit dispositif étant remarquable en ce qu'il comprend deux circuits analogues à celui décrit succinctement pour le deuxième dispositif, et recevant tous deux l'impulsion de tension *V* issue d'une unité de conversion, les paramètres de ces deux circuits étant réglés indépendamment l'un de l'autre, et un soustracteur analogique capable de produire un signal de sortie équivalent à la différence *Q* entre les charges analogiques respectives Q' et Q" transférées sur les seconds récepteurs de charge respectifs D'₂ et D"₂ contenus dans lesdits circuits.

Enfin, l'invention concerne, quatrièmement, un dispositif de traitement des signaux produits par un ensemble de détecteurs de particules, ledit dispositif étant remarquable en ce qu'au moins l'un de ces signaux est traité au moyen d'un dispositif tel que ceux décrits succinctement ci-dessus.

Pour chacun de ces dispositifs, les mesures s'effectuent en prélevant et lisant, à des moments prédéterminés, cette quantité analogique *Q*. Comme elle dépend de *V*ₘₐₓ. elle représente bien l'énergie du photon à l'origine de l'impulsion. En particulier, pour compter les photons reçus depuis la mesure précédente, il suffit de diviser *Q* par *Q*₂.

Les avantages offerts par ces dispositifs sont donc essentiellement les mêmes que ceux offerts par les procédés selon l'invention, mais on notera de surcroît qu'ils peuvent facilement être réalisés au moyen de composants à semi-conducteurs classiques, comme on le montrera dans la description détaillée ci-dessous, d'où le faible encombrement de ces dispositifs, ainsi qu'un faible coût de construction. Ces qualités résultent notamment du fait que le traitement selon l'invention du signal issu du détecteur est purement analogique. Naturellement, dans certaines applications, il pourra s'avérer utile de connecter à un dispositif selon l'invention un convertisseur analogique-numérique pour pouvoir traiter numériquement les informations obtenues, surtout si les contraintes de coût et d'encombrement sont secondaires dans le cadre de l'application envisagée.

Enfin, l'invention vise divers appareils d'analyse d'un flux de particules incorporant au moins un dispositif tel que ceux décrits succinctement ci-dessus.

D'autres aspects et avantages de l'invention apparaîtront à la lecture de la description détaillée, que l'on trouvera ci-dessous, de modes particuliers de réalisation donnés à titre d'exemples non limitatifs. Cette description se réfère aux dessins annexés, dans lesqueis :
- la figure 1 représente de façon schématique un dispositif conforme à un premier mode de réalisation de l'invention,
- les figures 2a à 2d représentent les étapes principales du fonctionnement du dispositif illustré sur la figure 1,
- la figure 3 représente de façon schématique la relation existant entre l'énergie *E* d'un photon incident et la quantité analogique *Q* qui lui est associée, quand on utilise le dispositif illustré sur la figure 1,
- la figure 4 représente de façon schématique un dispositif conforme à un deuxième mode de réalisation de l'invention,
- les figures 5 et 6 représentent les étapes principales du fonctionnement du dispositif illustré sur la figure 4,
- la figure 7 représente de façon schématique la relation existant entre l'énergie E d'un photon incident et la quantité analogique *Q* qui lui est associée, quand on utilise le dispositif illustré sur la figure 4,
- la figure 8 représente de façon schématique un dispositif conforme à un troisième mode de réalisation de l'invention, et
- les figures 9a à 9d représentent de façon schématique la relation existant entre l'énergie E d'un photon incident et la quantité analogique Q qui lui est associée, quand on utilise le dispositif illustré sur la figure 8 selon quatre réglages différents présentés ici à titre d'exemples.

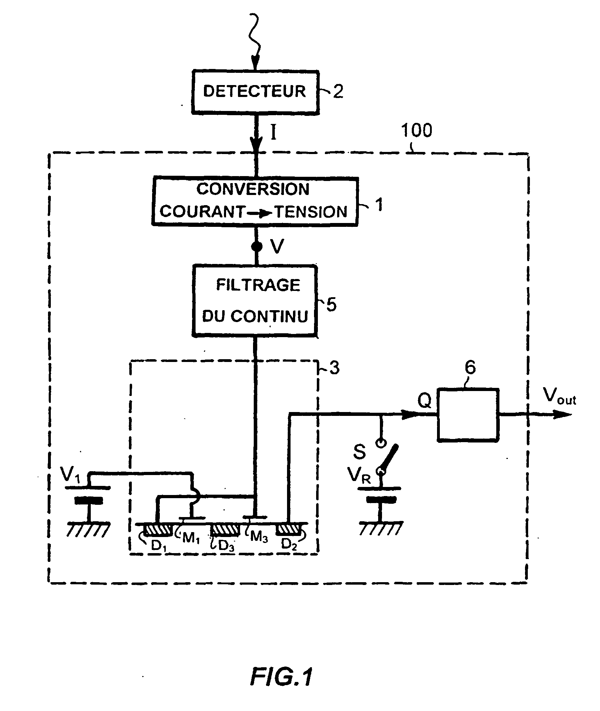

La **figure 1** représente, selon un premier mode de réalisation de l'invention, un dispositif 100 destiné à traiter les signaux émis par un détecteur de photons 2.

Ce détecteur 2 émet, en réponse à l'arrivée d'un photon sur sa surface réceptrice, une impulsion de courant *I*. Selon l'invention, on convertit d'abord cette impulsion de courant *I* en une impulsion de tension V à l'aide d'une unité adéquate classique 1.

Le signal résultant est ensuite, optionnellement, débarrassé de sa composante continue à l'aide d'une unité de filtrage classique 5. On rappelle que cette composante continue correspond à la valeur moyenne du courant d'obscurité et du courant de traînage sortant du détecteur 2, quel que soit ce détecteur.

Le signal est alors traité par le circuit analogique 3. L'impulsion de tension V est directement appliquée à une zone de diffusion D₁, qui joue ici le rôle de récepteur de charges électriques, et à la grille d'un transistor « MOS » (initiales de « Métal-Oxyde-Semi-conducteur ») M₃. Plus précisément, dans le mode de réalisation représenté, on a choisi pour M₃ un transistor de type « NMOS », c'est-à-dire à conduction par électrons ; le potentiel de canal en surface V* de M₃ est donc ici inférieur à *V* d'une certaine quantité ε.

Entre M₃ et D₁, on trouve une autre zone de diffusion D₃, qui joue le rôle de réservoir de charges, et un autre transistor NMOS M₁, dont la grille est maintenue à un potentiel fixe *V*₁ ; le potentiel de canal *V*₁* de M₁ est inférieur à *V*₁ d'une quantité proche de ε.

On trouve enfin, après le transistor M₃, une dernière zone de diffusion D₂, qui est destinée à recevoir la charge analogique Q selon l'invention.

Pour effectuer une mesure, on porte pendant un bref instant cette zone de diffusion D₂ à un potentiel fixe prédéterminé V_{R} (en fermant puis en ouvrant l'interrupteur S). La charge Q accumulée dans D₂ engendre alors une variation de tension qui est lue par un appareil de mesure 6 (par exemple un condensateur avec voltmètre, ou un galvanomètre balistique) délivrant le signal de sortie du dispositif Vₒᵤₜ.

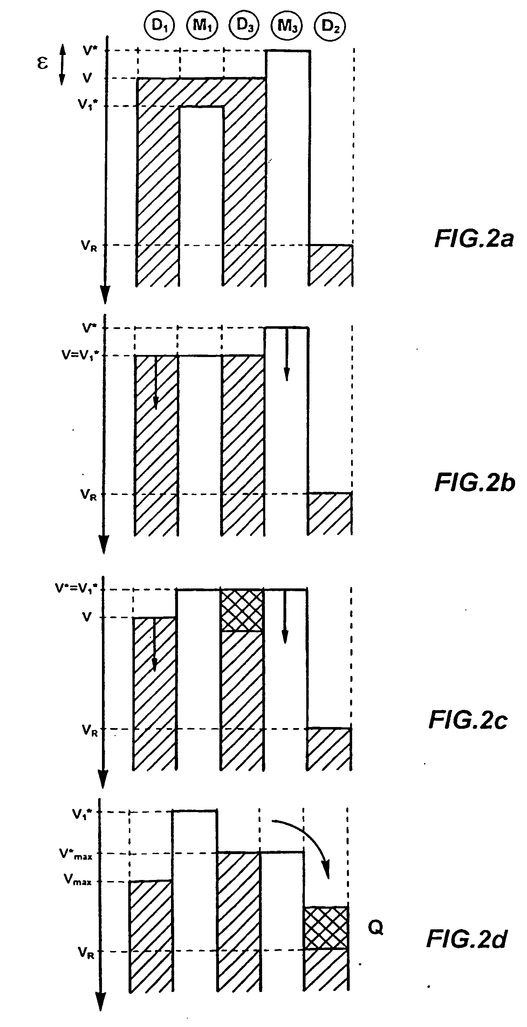

La **figure 2** représente les étapes principales du fonctionnement du dispositif illustré sur la figure 1, en montrant de manière schématique, pour chaque étape, la relation entre les potentiels de D₁, D₂, D₃, et des canaux de M₁ et M₃, dans le cas où l'on choisit la valeur de *V*₁ de telle manière que la valeur de *V*₁* = *V*₁ - ε soit supérieure à la valeur moyenne du bruit de fond, dans le dispositif 100 sans unité de filtrage 5 (ou soit positive, si on incorpore une telle unité 5).

La figure 2a montre les valeurs de ces potentiels en l'absence d'impulsion provenant du détecteur 2. On voit notamment que les charges situées dans D₃ peuvent se déverser dans D₁, mais pas dans D₂, en raison de la barrière de potentiel présentée par le canal de M₃.

Suite à la réception d'un photon par le détecteur (ou du fait d'une fluctuation du bruit de fond), les potentiels de D₁ (à savoir *V*) et de M₃ (à savoir *V** = *V* - ε) augmentent de conserve. Si l'impulsion est suffisamment forte, on atteint l'étape illustrée sur la figure 2b, où la communication entre D₃ et D₁ se coupe.

Si l'impulsion est suffisamment forte, on atteint ensuite l'étape illustrée sur la figure 2c, où les charges contenues dans D₃ peuvent commencer à se déverser dans D₂. La quantité de charges ainsi déversée pour une tension V donnée dépend de la capacité parasite de D₃.

Quand l'impulsion *V* atteint son maximum *V*ₘₐₓ (figure 2d), la charge déversée sur D₂ a atteint une certaine valeur Q.

La tension *V* décroît ensuite, et M₃ forme immédiatement une barrière de potentiel entre D₃ et D₂, de sorte qu'il ne se déverse pas de charge supplémentaire sur D₂. La charge Q conserve donc bien la valeur qu'elle avait acquise au pic de l'impulsion.

L'on revient enfin dans la situation de la figure 2a jusqu'à l'arrivée d'une nouvelle impulsion. On veillera, compte tenu de la fréquence pratique d'arrivée des photons, à ce que la recharge de D₃ à partir de D₁ soit suffisamment rapide pour que le dispositif soit prêt pour cette nouvelle impulsion.

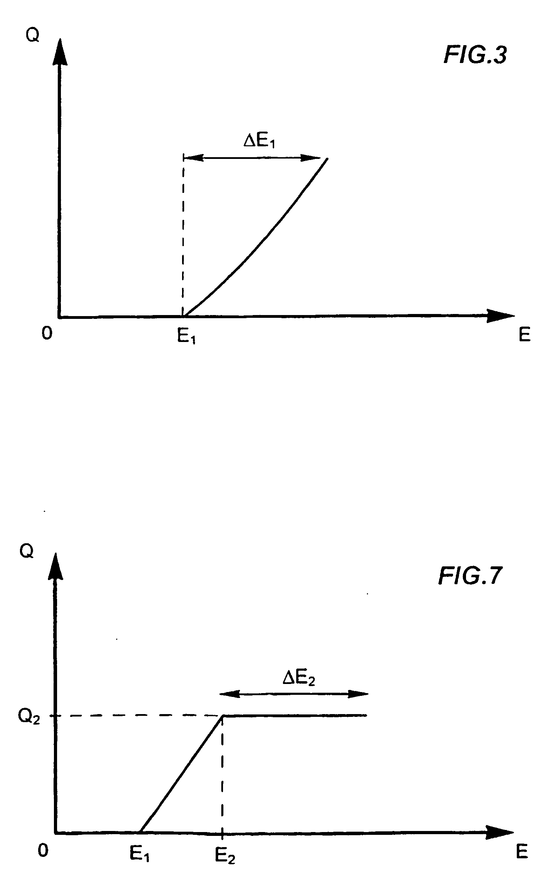

La **figure 3** montre l'allure de la fonction *Q*(*E*) (où *E* est l'énergie du photon incident à l'origine de l'impulsion de tension *V*) associée au dispositif 100. Cette courbe *Q*(*E*) se caractérise par un seuil de détection *E*₁ correspondant à une impulsion de tension dont le pic *V*ₘₐₓ est égal à la tension *V*₁. On observe ensuite une portion croissante, au moins sur une bande d'énergie des photons Δ*E*₁ correspondant à une plage de valeurs Δ*V*₁ de *V* sur laquelle le circuit 3 se comporte fidèlement de la manière décrite ci-dessus.

Au cas où il importe, pour l'application envisagée, de disposer d'une croissance linéaire, on pourra, par exemple, remplacer la zone de diffusion D₃ par un transistor NMOS dont la grille sera polarisée à un potentiel supérieur à la plus grande valeur attendue pour *V*ₘₐₓ; ou bien on pourra connecter à la zone de diffusion D₃ l'armature d'un condensateur dont l'autre armature est polarisée à un potentiel fixe.

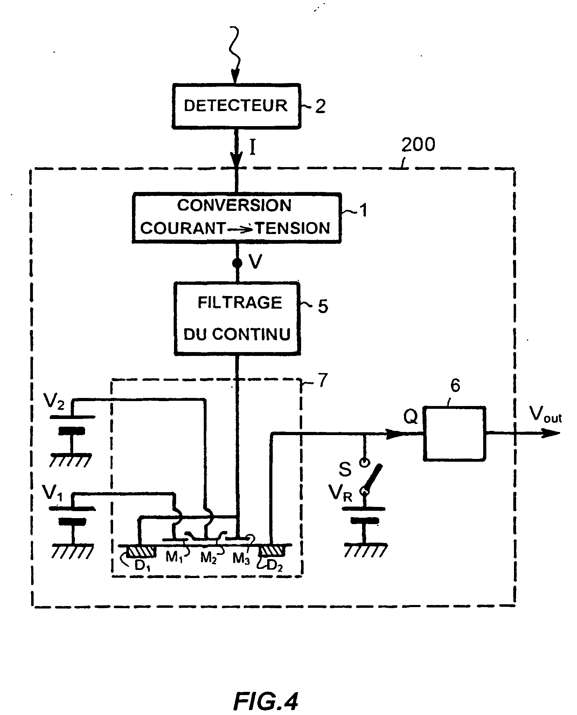

La **figure 4** représente, selon un deuxième mode de réalisation de l'invention, un dispositif 200 destiné à traiter les signaux émis par un détecteur de photons 2.

Ce dispositif 200 ne diffère du dispositif 100, et plus précisément le circuit 7 ne diffère du circuit 3, que par le remplacement de la zone de diffusion D₃ par un transistor NMOS M₂, dont la grille est portée à un potentiel fixe *V*₂.

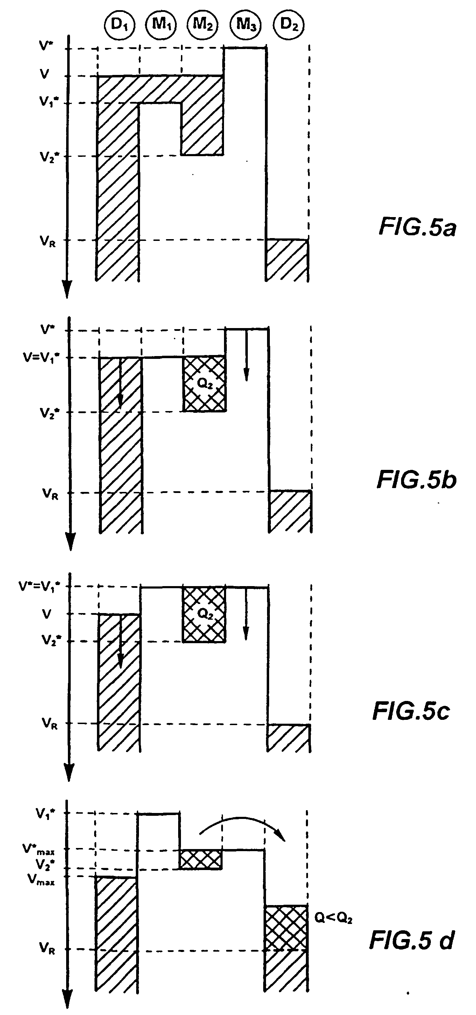

La **figure 5** représente les étapes principales du fonctionnement du dispositif illustré sur la figure 4, pour un photon dont l'énergie E est inférieure à *E*₂, où *E*₂ correspond à une impulsion de tension dont le pic *V*ₘₐₓ est égal à la tension *V*₂.

Le fonctionnement du dispositif dans ce cas est tout à fait analogue au fonctionnement décrit en référence à la figure 2. Il est vrai que dans le présent dispositif, quand *E* est supérieure à *E*₁ (la valeur qui correspond à une impulsion de tension dont le pic *V*ₘₐₓ est égal à la tension *V*₁), on atteint un stade (à partir de la figure 5b) où l'on isole une certaine charge Q₂ dans le canal de M₂, ce qui n'était pas le cas avec le dispositif de la figure 1 ; mais la valeur de cette charge *Q*₂ n'a aucun effet sur le fonctionnement du présent dispositif si *E* est inférieure à *E*₂.

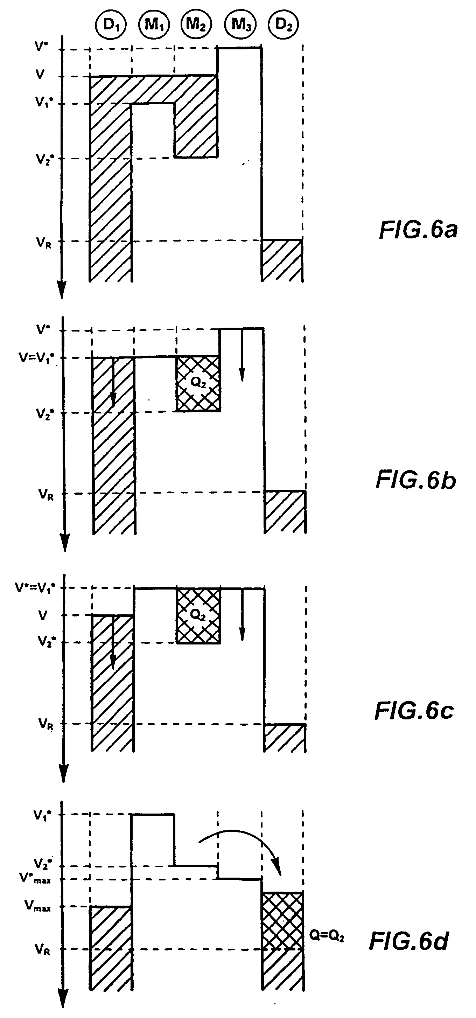

Examinons donc, à l'aide de la **figure 6**, les étapes principales du fonctionnement du dispositif 200 pour un photon dont l'énergie *E* est supérieure à ladite valeur *E*₂.

Les étapes 6a à 6c sont identiques aux étapes respectives 5a à 5c. Ensuite la charge *Q*₂ se déverse comme précédemment de M₂ vers D₂, mais, quand *V* continue à croître, on atteint un stade (*V** > *V*₂*, où *V*₂* = *V*₂ - ε, et donc *V* > *V*₂) où cette charge est épuisée. Quand donc la tension *V* atteint son maximum *V*ₘₐₓ (figure 6d), la charge déposée dans D₂ est égale à *Q*₂ indépendamment de la valeur de ce maximum (supposé supérieur à *V*₂).

Le retour à l'état initial (figure 6a) est analogue au retour à l'état initial dans les dispositifs précédents.

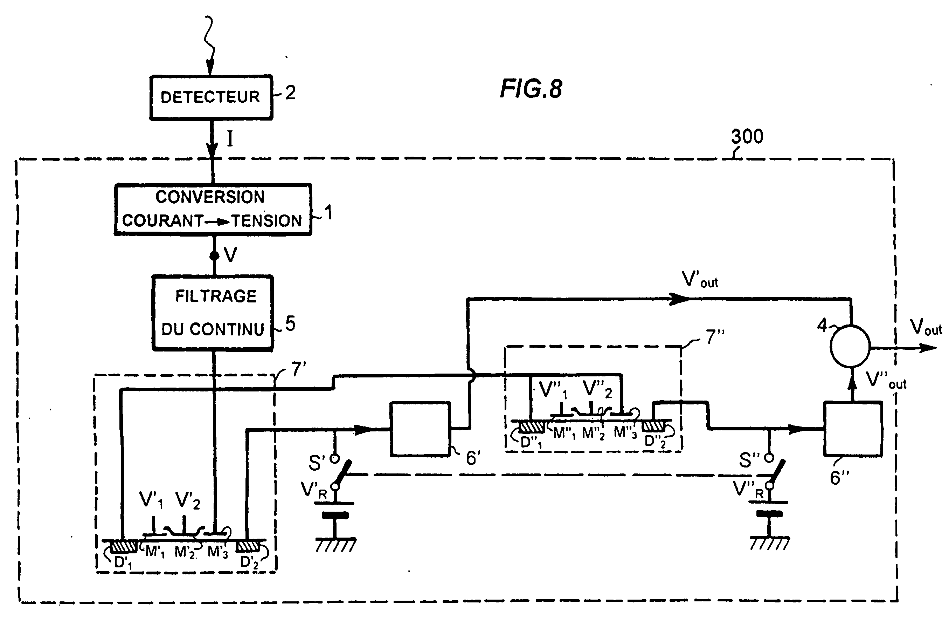

La **figure 7** montre l'allure de la fonction *Q*(*E*) associée au dispositif 200.

Cette courbe *Q*(*E*) se caractérise par un seuil de détection *E*₁, suivi d'une portion croissante dont la pente est déterminée par la capacité de M₂. Ensuite, la fonction reste constante à la valeur *Q*₂ = *Q*(*E*₂), au moins sur une bande d'énergie des photons Δ*E*₂ correspondant à une plage de valeurs Δ*V*₂ de *V* au-dessus de *V*₂, sur laquelle le circuit 7 se comporte fidèlement de la manière décrite ci-dessus.

La **figure 8** représente, selon un troisième mode de réalisation de l'invention, un dispositif 300 destiné à traiter les signaux émis par un détecteur de photons 2.

Ce dispositif 300 comprend, outre une unité de conversion du courant en tension 1 et (optionnellement) une unité de filtrage 5, deux circuits 7' et 7" fonctionnellement analogues au circuit 7 du dispositif 200. Les charges *Q*' et *Q*" cumulées respectivement sur D'₂ et D"₂ produisent, après mesure dans les unités 6' et 6", des signaux de sortie respectifs *V*'ₒᵤₜ et *V*"ₒᵤₜ qui sont envoyés vers un soustracteur analogique 4, de sorte que le signal de sortie du dispositif 300 est *V*ₒᵤₜ = *V*'ₒᵤₜ - *V*"ₒᵤₜ.

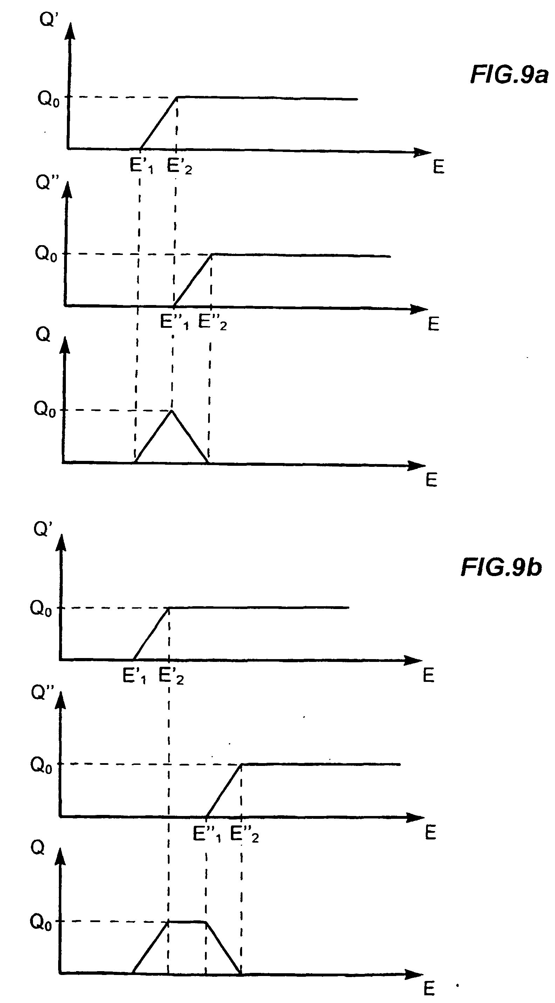

Les **figures 9a à 9d** montrent l'allure de la fonction *Q*(*E*) (où Q est ici définie comme étant égale à (Q'-Q")) associée au dispositif 300, pour différentes valeurs de *V*'₁, *V*'₂, *Q*'₂, *V*"₁. *V*"₂, et *Q*"₂.

Dans le cas de la figure 9a, on prend pour *Q*'₂ et *Q*"₂ une valeur commune (appelée *Q*₀), et des capacités égales pour M'₂ et M"₂ (de manière à obtenir des pentes égales dans la partie croissante des fonctions *Q*'(*E*) et *Q*"(*E*)), et de plus : *V*"1 = *V*'₂. On obtient alors une courbe *Q*(*E*) triangulaire.

On peut souhaiter élargir le sommet de cette courbe, de manière à ce qu'elle ressemble plus à une dent, ou à une Gaussienne. Pour ce faire (figure 9b), il suffit de prendre *V*"₁ > *V*'₂.

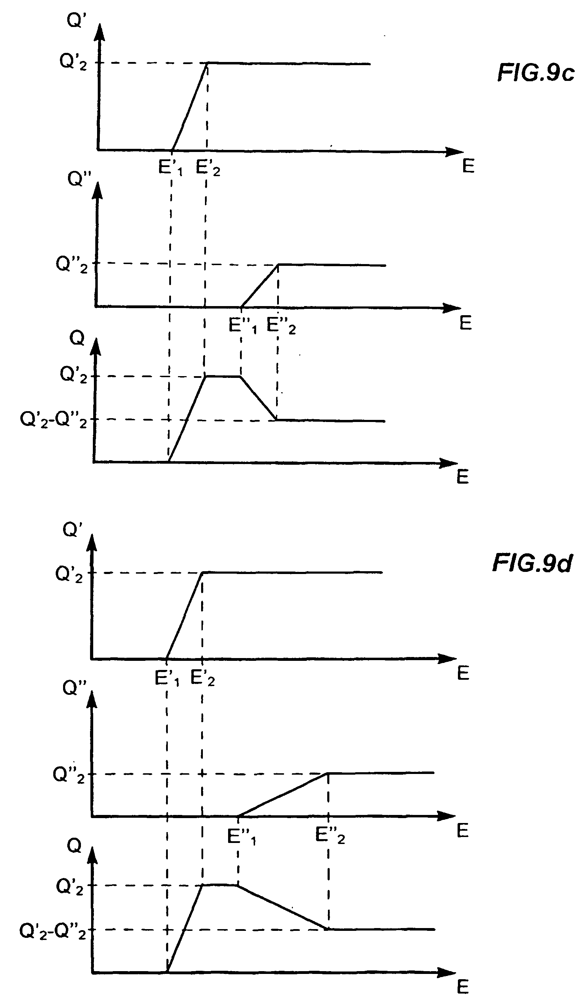

En prenant *Q*'₂ supérieure à *Q*"₂ (figure 9c), on obtient un créneau qui maintient une valeur non nulle de *Q* au-delà de *E* = *E'*₂.

En prenant des capacités différentes pour M'₂ et M"₂ (figure 9d), on obtient des pentes asymétriques pour la partie croissante et la partie décroissante de *Q*(*E*).

Sur la base de ces quelques exemples, l'homme du métier saura aisément choisir parmi les nombreux réglages de paramètres possibles afin d'obtenir la fonction *Q*(*E*) souhaitable en fonction de l'application considérée, parmi une large gamme de formes fonctionnelles possibles.

Par ailleurs, il va de soi que les dispositifs illustrés sur les figures 1, 4 et 7 sont des exemples délibérément simples de réalisations capables de fournir les fonctions *Q*(*E*) illustrées respectivement sur les figures 3, 7 et 9. En pratique, l'homme du métier saura les modifier selon des techniques connues, pour y apporter des avantages secondaires tels que l'insensibilité aux bruits parasites, une vitesse de transfert des charges à travers le dispositif qui soit suffisamment rapide, ou la stabilité des sources de courant, amplificateurs ou transformateurs utilisés.

De plus, pour fixer les idées, on a fait, dans la description ci-dessus, l'hypothèse que l'impulsion de tension en sortie du convertisseur courant/tension est positive. Dans le cas d'impulsions négatives, l'homme du métier saura sans peine adapter les dispositifs décrits, par exemple en remplaçant les transistors NMOS par des transistors « PMOS » (à conduction par trous).

On a décrit ci-dessus l'invention en faisant référence à la charge analogique Q cumulée sur un détecteur qui peut être soit un détecteur unique, soit un pixel individuel au sein d'un détecteur multipixels, c'est-à-dire constitué d'une matrice ou d'une barrette de pixels.

Dans le cas d'un détecteur multipixel, rien n'empêche bien sûr, en cas de besoin, de sommer les charges analogiques cumulées sur plusieurs de ces pixels. Cette sommation offre par exemple un avantage particulier dans le cas du comptage, si l'on suppose que l'énergie des photons à compter est, comme c'est souvent le cas, comprise dans une bande relativement étroite située légèrement au-dessus d'un seuil de comptage *E*₂. La présente invention permet alors de corriger les erreurs de comptage qui pourraient résulter du fait qu'un certain photon arrive entre deux pixels (ce qui engendre en sortie de chaque pixel des signaux *I*ₐ et *I*_{b} dont la somme est égale au signal *I* qui aurait été engendré si ledit photon était arrivé à l'intérieur d'un seul pixel).

En effet, si l'on utilise un dispositif classique, aucun de ces deux signaux *I*ₐ et *I*_{b} ne sera suffisant pour déclencher le compteur associé au pixel respectif, de sorte que ledit photon ne sera pas comptabilisé. En revanche, si l'on utilise un dispositif selon l'invention, on enregistrera une quantité analogique *Q*ₐ proportionnelle à *I*ₐ, et une quantité analogique *Q*_{b} proportionnelle à *I*_{b}, de sorte que la somme *Q* = *Q*ₐ + *Q*_{b} sera à peu près égale à *Q*₂, et ce photon sera correctement comptabilisé.

On notera pour terminer que la présente invention peut être considérée dans son ensemble d'un autre point de vue que celui présenté dans l'introduction. En effet, les multiples exemples présentés en détail ci-dessus illustrent le fait que le traitement du signal selon l'invention conduit à une charge analogique *Q* qui représente, d'une manière prédéterminée, l'énergie *E* des photons incidents. Autrement dit, la fonction *Q*(*E*) joue le rôle d'une « fonction de pondération » au moyen de laquelle on peut attribuer, en cas de besoin, un « poids » différent à chaque photon selon son énergie. On a aussi montré, dans le cas des fonctions de pondération présentées, comment les obtenir concrètement au moyen de dispositifs utilisant des composants électroniques analogiques classiques. L'homme du métier saura, en s'inspirant de ces exemples, mettre au point un dispositif adéquat pour obtenir essentiellement toute fonction de pondération souhaitable en fonction de l'application envisagée, ou même un dispositif offrant des possibilités de réglage permettant d'obtenir diverses formes de courbes de pondération adéquates pour une gamme d'applications envisagées.

## Revendications

1. Procédé de traitement du signal émis par un détecteur de particules, **caractérisé en ce que**
l'on détecte dans ledit signal les portions où le signal est supérieur à une valeur prédéterminée *V*₁,
l'on mesure la valeur maximale *V*ₘₐₓ atteinte par le signal dans chacune desdites portions, et
l'on associe à chacune desdites portions une charge électrique *Q* qui, au moins sur une plage de valeurs prédéterminée Δ*V*₁ de ladite valeur maximale *V*ₘₐₓ, est une fonction croissante de (*V*ₘₐₓ - *V*₁).

2. Procédé de traitement du signal selon la revendication 1, **caractérisé en ce que** la valeur de *V*₁ est au moins égale au niveau moyen du bruit de fond présent dans le signal émis par le détecteur.

3. Procédé de traitement du signal selon la revendication 1 ou la revendication 2, **caractérisé en ce que**, sur ladite plage Δ*V*₁ de valeurs de Vₘₐₓ, ladite charge électrique Q est proportionnelle à (*V*ₘₐₓ - *V*₁).

4. Procédé de traitement du signal selon la revendication 1 ou la revendication 2, **caractérisé en ce que** l'on associe à chacune desdites portions une charge électrique *Q* qui
est une fonction croissante de (*V*ₘₐₓ - *V*₁) si la valeur maximale *V*ₘₐₓ est inférieure à une deuxième valeur prédéterminée *V*₂, et
reste constante à sa valeur pour *V*ₘₐₓ = *V*₂ si la valeur maximale *V*ₘₐₓ est supérieure à cette deuxième valeur *V*₂, au moins sur une plage de valeurs prédéterminée Δ*V*₂ de ladite valeur maximale *V*ₘₐₓ.

5. Procédé de traitement du signal selon la revendication 3 et la revendication 4, **caractérisé en ce que** l'on associe à chacune desdites portions une charge électrique *Q* qui
est proportionnelle à (*V*ₘₐₓ - *V*₁) si la valeur maximale *V*ₘₐₓ est inférieure à une deuxième valeur prédéterminée *V*₂, et
reste constante à sa valeur pour *V*ₘₐₓ = *V*₂ si la valeur maximale *V*ₘₐₓ est supérieure à cette deuxième valeur *V*₂, au moins sur une plage de valeurs prédéterminée Δ*V*₂ de ladite valeur maximale *V*ₘₐₓ.

6. Procédé de traitement du signal selon la revendication 4, **caractérisé en ce que** l'on associe à chacune desdites portions une charge électrique *Q* qui
est une fonction croissante de (*V*ₘₐₓ - *V*₁) si la valeur maximale *V*ₘₐₓ est inférieure à une deuxième valeur prédéterminée *V*₂,
reste constante à sa valeur pour *V*ₘₐₓ = *V*₂ si la valeur maximale *V*ₘₐₓ est comprise entre cette deuxième valeur *V*₂ et une troisième valeur prédéterminée *V*₃, et
est une fonction décroissante de *V*ₘₐₓ si la valeur maximale *V*ₘₐₓ est supérieure à cette troisième valeur *V*₃, au moins sur une plage de valeurs prédéterminée Δ*V*₃ de ladite valeur maximale *V*ₘₐₓ.

7. Procédé de traitement du signal selon l'une quelconque des revendications précédentes, **caractérisé en ce que** lesdites particules sont des photons.

8. Dispositif (100,200) de traitement du signal produit par un détecteur de particules (2), comprenant
- une unité de conversion (1) capable de transformer toute impulsion de courant issue dudit détecteur (2) en une impulsion de tension *V*,
- un circuit analogique (3,7) comportant
un réservoir de charges électriques (D₃, M₂),
un premier récepteur de charges électriques (D₁) pouvant être alimenté par ledit réservoir de charges (D₃, M₂) de manière commandable au moyen de ladite tension *V*, et
un second récepteur de charges électriques (D₂) pouvant lui aussi être alimenté par ledit réservoir de charges (D₃, M₂) de manière commandable au moyen de ladite tension *V*, et
- un appareil de mesure (6) de la charge électrique *Q* contenue dans ledit second récepteur de charges (D₂),
ledit circuit analogique (3,7) étant conçu de manière à ce que chaque impulsion de tension *V* produise successivement au sein dudit dispositif les effets suivants :
a) ledit réservoir de charges (D₃, M₂) est isolé dudit premier récepteur de charges (D₁),
b) le réservoir de charges (D₃, M₂) est connecté audit second récepteur de charges (D₂) quand la tension V dépasse une valeur prédéterminée *V*₁,
c) il passe du réservoir de charges (D₃, M₂) au second récepteur de charges (D₂) une charge électrique *Q* qui, au moins sur une plage de valeurs prédéterminée Δ*V*₁ de *V*, est une fonction croissante de (*V* - *V*₁),
d) la connexion entre le réservoir de charges (D₃, M₂) et le second récepteur de charges (D₂) est coupée quand la tension *V* commence à décroître après avoir atteint une valeur maximale *V*ₘₐₓ, et
e) le réservoir de charges (D₃, M₂) est reconnecté au premier récepteur de charges (D₁) qui restaure dans le réservoir de charges (D₃, M₂) la charge électrique *Q* perdue.

9. Dispositif (200) de traitement du signal selon la revendication 8, **caractérisé en ce que**, lors dudit effet c), il passe du réservoir de charges (M₂) au second récepteur de charges (D₂) une charge électrique *Q* proportionnelle à (*V* - *V*₁) si la tension *V* ne dépasse pas une deuxième valeur prédéterminée *V*₂, ou proportionnelle à (*V*₂ - *V*₁) si la tension V dépasse ladite deuxième valeur *V*₂.

10. Dispositif (300) de traitement du signal produit par un détecteur de particules (2), **caractérisé en ce qu'**il comprend deux circuits (7', 7") selon la revendication 9 recevant tous deux l'impulsion de tension *V* issue d'une unité de conversion (1), les paramètres de ces deux circuits (7', 7") étant réglés indépendamment l'un de l'autre, et un soustracteur analogique (4) capable produire un signal de sortie équivalent à la différence *Q* entre les charges électriques respectives Q' et Q" transférées sur les seconds récepteurs de charge respectifs (D'₂) et (D"₂) contenus dans lesdits circuits (7', 7").

11. Dispositif de traitement des signaux produits par un ensemble de détecteurs de particules, **caractérisé en ce qu'**au moins l'un de ces signaux est traité au moyen d'un dispositif selon l'une quelconque des revendications 8 à 10.

12. Dispositif de traitement de signaux selon l'une quelconque des revendications 8 à 11, **caractérisé en ce que** lesdites particules sont des photons.

13. Appareil de radiologie, **caractérisé en ce qu'**il comprend au moins un dispositif selon l'une quelconque des revendications 8 à 11.

14. Appareil d'imagerie vidéo, **caractérisé en ce qu'**il comprend au moins un dispositif selon l'une quelconque des revendications 8 à 11.

15. Appareil de fluoroscopie, **caractérisé en ce qu'**il comprend au moins un dispositif selon l'une quelconque des revendications 8 à 11.

## Patentansprüche

1. Verfahren zum Verarbeiten eines Signals, das von einem Teilchendetektor ausgesendet wird, **dadurch gekennzeichnet, dass**
in dem Signal jene Abschnitte erfasst werden, in denen das Signal größer als ein vorgegebener Wert V₁ ist,
der maximale Wert Vₘₐₓ gemessen wird, den das Signal in jedem dieser Abschnitte erreicht, und
jedem dieser Abschnitte eine elektrische Ladung Q zugeordnet wird, die wenigstens in einem vorgegebenen Wertebereich Δ*V*₁ des maximalen Wertes Vₘₐₓ eine wachsende Funktion von (Vₘₐₓ - V₁) ist.

2. Signalverarbeitungsverfahren nach Anspruch 1, **dadurch gekennzeichnet, dass** der Wert (V₁) wenigstens gleich dem mittleren Pegel des Grundrauschens ist, das in dem von dem Detektor ausgesendeten Signal vorhanden ist.

3. Signalverarbeitungsverfahren nach Anspruch 1 oder Anspruch 2, **dadurch gekennzeichnet, dass** in dem Bereich ΔV1 von Werten Vₘₐₓ die elektrische Ladung Q zu (Vₘₐₓ - V₁) proportional ist.

4. Signalverarbeitungsverfahren nach Anspruch 1 oder Anspruch 2, **dadurch gekennzeichnet, dass** jedem der Abschnitte eine elektrische Ladung Q zugeordnet ist, die
eine wachsende Funktion von (Vₘₐₓ - V₁) ist, wenn der maximale Wert Vₘₐₓ kleiner als ein zweiter vorgegebener Wert V₂ ist, und
wenigstens in einem vorgegebenen Wertebereich ΔV₂ des maximalen Wertes Vₘₐₓ für Vₘₐₓ = V₂ konstant auf ihrem Wert bleibt, wenn der maximale Wert Vₘₐₓ größer als der zweite Wert V₂ ist.

5. Signalverarbeitungsverfahren nach Anspruch 3 und Anspruch 4, **dadurch gekennzeichnet, dass** jedem dieser Abschnitte eine elektrische Ladung Q zugeordnet ist, die
zu (Vₘₐₓ - V₁) proportional ist, wenn der maximale Wert Vₘₐₓ kleiner als ein zweiter vorgegebener Wert V₂ ist, und
wenigstens in einem vorgegebenen Wertebereich ΔV₂ des maximalen Wertes Vₘₐₓ für Vₘₐₓ = V₂ konstant auf ihrem Wert bleibt, wenn der maximale Wert Vₘₐₓ größer als der zweite Wert V₂ ist.

6. Signalverarbeitungsverfahren nach Anspruch 4, **dadurch gekennzeichnet, dass** jedem dieser Abschnitte eine elektrische Ladung Q zugeordnet wird, die
eine wachsende Funktion von (Vₘₐₓ - V₁) ist, wenn der maximale Wert Vₘₐₓ kleiner als ein zweiter vorgegebener Wert V₂ ist,
für Vₘₐₓ = V₂ auf seinem Wert konstant bleibt, wenn der maximale Wert Vₘₐₓ zwischen diesem zweiten Wert V₂ und einem dritten vorgegebenen Wert V₃ liegt, und
wenigstens in einem vorgegebenen Wertebereich ΔV₃ des maximalen Wertes Vₘₐₓ eine fallende Funktion von Vₘₐₓ ist, wenn der maximale Wert Vₘₐₓ größer als dieser dritte Wert V₃ ist.

7. Signalverarbeitungsverfahren nach einem der vorhergehenden Ansprüche, **dadurch gekennzeichnet, dass** die Teilchen Photonen sind.

8. Vorrichtung (100, 200) für die Verarbeitung eines Signals, das durch einen Teilchendetektor (2) erzeugt wird, die umfasst:
- eine Umsetzungseinheit (1), die jeden Stromimpuls, der vom Detektor (2) ausgegeben wird, in einen Spannungsimpuls V transformieren kann,
- eine analoge Schaltung (3, 7), die versehen ist mit
einem Reservoir (D₃, M₂) für elektrische Ladungen,
einem ersten Empfänger (D₁) für elektrische Ladungen, der durch das Ladungsreservoir (D₃, M₂) in einer mittels der Spannung V steuerbaren Weise versorgt werden kann, und
einem zweiten Empfänger (D₂) für elektrische Ladungen, der ebenfalls durch das Ladungsreservoir (D₃, M₂) in einer mittels der Spannung V steuerbaren Weise versorgt werden kann, und
- ein Messgerät (6) für die elektrische Ladung Q, die in dem zweiten Ladungsempfänger (D₂) enthalten ist,
wobei die analoge Schaltung (3, 7) so beschaffen ist, dass jeder Spannungsimpuls V nacheinander in der Vorrichtung die folgenden Wirkungen hervorruft:
a) das Ladungsreservoir (D₃, M₂) wird von dem ersten Ladungsempfänger (D₁) isoliert,
b) das Ladungsreservoir (D₃, M₂) wird mit dem zweiten Ladungsempfänger (D₂) verbunden, wenn die Spannung V einen vorgegebenen Wert V₁ übersteigt,
c) eine elektrische Ladung Q bewegt sich vom Ladungsreservoir (D₃, M₂) zum zweiten Ladungsempfänger (D2), die wenigstens in einem vorgegebenen Wertebereich ΔV₁ von V eine wachsende Funktion von (V - V₁) ist,
d) die Verbindung zwischen dem Ladungsreservoir (D₃, M₂) und dem zweiten Ladungsempfänger (D₂) wird getrennt, wenn die Spannung V abzunehmen beginnt, nachdem sie einen maximalen Wert Vₘₐₓ erreicht hat, und
e) das Ladungsreservoir (D₃, M₂) wird wieder mit dem ersten Ladungsempfänger (D₁) verbunden, der in dem Ladungsreservoir (D₃, M₂) die verlorene elektrische Ladung Q wiederherstellt.

9. Signalverarbeitungsvorrichtung (200) nach Anspruch 8, **dadurch gekennzeichnet, dass** sich bei der Wirkung c) eine elektrische Ladung Q vom Ladungsreservoir (M₂) zum zweiten Ladungsempfänger (D₂) bewegt, wobei die elektrische Ladung Q entweder zu (V - V₁) proportional ist, wenn die Spannung V einen zweiten vorgegebenen Wert V₂ nicht übersteigt, oder zu (V₂ - V₁) proportional ist, wenn die Spannung V den zweiten Wert V₂ übersteigt.

10. Vorrichtung (300) für die Verarbeitung eines Signals, das durch einen Teilchendetektor (2) erzeugt wird, **dadurch gekennzeichnet, dass** sie umfasst: zwei Schaltungen (7', 7") nach Anspruch 9, die jeweils zwei Spannungsimpulse V empfangen, die von einer Umsetzungseinheit (1) ausgegeben werden, wobei die Parameter dieser beiden Schaltungen (7', 7") unabhängig voneinander geregelt werden, und einen analogen Subtrahierer (4), der ein Ausgangssignal erzeugen kann, das zur Differenz Q zwischen den jeweiligen elektrischen Ladungen Q', Q", die an die jeweiligen zweiten Ladungsempfänger (D'₂) und (D"₂), die in den Schaltungen (7', 7") enthalten sind, übertragen werden, äquivalent ist.

11. Vorrichtung zur Verarbeitung von Signalen, die von einer Gesamtheit von Teilchendetektoren erzeugt werden, **dadurch gekennzeichnet, dass** wenigstens eines dieser Signale mittels einer Vorrichtung nach einem der Ansprüche 8 bis 10 verarbeitet wird.

12. Signalverarbeitungsvorrichtung nach einem der Ansprüche 8 bis 11, **dadurch gekennzeichnet, dass** die Teilchen Photonen sind.

13. Röntgenapparat, **dadurch gekennzeichnet, dass** er wenigstens eine Vorrichtung nach einem der Ansprüche 8 bis 11 umfasst.

14. Videoabbildungsgerät, **dadurch gekennzeichnet, dass** es wenigstens eine Vorrichtung nach einem der Ansprüche 8 bis 11 umfasst.

15. Fluoroskopievorrichtung, **dadurch gekennzeichnet, dass** sie wenigstens eine Vorrichtung nach einem der Ansprüche 8 bis 11 umfasst.

## Claims

1. Method of processing the signal emitted by a particle detector, **characterized in that**
the portions where the signal is above a predetermined value V₁ are detected in the said signal,
the maximum value *V*ₘₐₓ reached by the signal in each of the said portions is measured, and
an electric charge *Q* which, at least over a predetermined range of values Δ*V*₁ of the said maximum value *V*ₘₐₓ, is an increasing function of (*V*ₘₐₓ - *V*₁), is assigned to each of the said portions.

2. Method of signal processing according to claim 1, **characterized in that** the value of *V*₁ is at least equal to the average level of the background noise present in the signal emitted by the detector.

3. Method of signal processing according to claim 1 or claim 2, **characterized in that**, over the said range Δ*V*₁ of values of *V*ₘₐₓ, the said electric charge Q is proportional to (*V*ₘₐₓ - *V*₁).

4. Method of signal processing according to claim 1 or claim 2, **characterized in that** there is assigned to each of the said portions an electric charge *Q* which
is an increasing function of (*V*ₘₐₓ - *V*₁) if the maximum value *V*ₘₐₓ is below a second predetermined value *V*₂, and
remains constant at its value for *V*ₘₐₓ = *V*₂ if the maximum value *V*ₘₐₓ is above this second value *V*₂, at least over a predetermined range of values Δ*V*₂ of the said maximum value *V*ₘₐₓ.

5. Method of signal processing according to claim 3 and claim 4, **characterized in that** there is assigned to each of the said portions an electric charge *Q* which
is proportional to (*V*ₘₐₓ - *V*₁) if the maximum value *V*ₘₐₓ is below a second predetermined value *V*₂, and
remains constant at its value for *V*ₘₐₓ = *V*₂ if the maximum value *V*ₘₐₓ is above this second value *V*₂, at least over a predetermined range of values Δ*V*₂ of the said maximum value *V*ₘₐₓ.

6. Method of signal processing according to claim 4, **characterized in that** there is assigned to each of the said portions an electric charge *Q* which
is an increasing function of (*V*ₘₐₓ - *V*₁) if the maximum value *V*ₘₐₓ is below a second predetermined value *V*₂,
remains constant at its value for *V*ₘₐₓ = *V*₂ if the maximum value *V*ₘₐₓ is between this second value *V*₂ and a third predetermined value *V*₃, and
is a decreasing function of *V*ₘₐₓ if the maximum value *V*ₘₐₓ is above this third value *V*₃, at least over a predetermined range of values Δ*V*₃ of the said maximum value *V*ₘₐₓ.

7. Method of signal processing according to any one of the preceding claims, **characterized in that** the said particles are photons.

8. Device (100, 200) for processing the signal produced by a particle detector (2), comprising
- a conversion unit (1) that is able to convert any current pulse emitted from the said detector (2) into a voltage pulse *V*,
- an analogue circuit (3, 7) comprising
an electric charge storage device (D₃, M₂),
a first electric charge receiver (D₁) which can be fed by the said charge storage device (D₃, M₂) in a manner controllable by means of the said voltage *V*, and
a second electric charge receiver (D₂) which can also be fed by the said charge storage device (D₃, M₂) in a manner controllable by means of the said voltage *V*, and
- an apparatus (6) for measuring the electric charge *Q* contained in the said second charge receiver (D₂),
the said analogue circuit (3, 7) being designed so that each voltage pulse *V* produces the following effects successively within the said device:
a) the said charge storage device (D₃, M₂) is isolated from the said first charge receiver (D₁),
b) the charge storage device (D₃, M₂) is connected to the said second charge receiver (D₂) when the voltage V exceeds a predetermined value *V*₁,
c) an electric charge Q that, at least over a predetermined range of values from Δ*V*₁ of *V*, is an increasing function of (*V* - *V*₁), passes from the charge storage device (D₃, M₂) to the second charge receiver (D₂),
d) the connection between the charge storage device (D₃, M₂) and the second charge receiver (D₂) is cut when the voltage V begins to decrease after reaching a maximum value *V*ₘₐₓ, and
e) the charge storage device (D₃, M₂) is reconnected to the first charge receiver (D₁) which restores in the charge storage device (D₃, M₂) the electric charge Q that was lost.

9. Device (200) for processing the signal according to claim 8, **characterized in that**, when said effect c) occurs, an electric charge Q proportional to (*V* - *V*₁) passes from the charge storage device (M₂) to the second charge receiver (D₂) if the voltage V does not exceed a second predetermined value *V*₂, or proportional to (*V*₂ - *V*₁) if the voltage V exceeds said second value *V*₂.

10. Device (300) for processing the signal produced by a particle detector (2), **characterized in that** it comprises two circuits (7', 7") according to claim 9 both receiving the voltage pulse V emitted from a conversion unit (1), the parameters of these two circuits (7', 7") being controlled independently of one another, and an analogue subtractor (4) that is able to produce an output signal equivalent to the difference Q between the respective electric charges *Q*' and *Q*" transferred to the respective second charge receivers (D'₂) and (D"₂) contained in the said circuits (7', 7").

11. Device for processing the signals produced by a set of particle detectors, **characterized in that** at least one of these signals is processed by means of a device according to any one of claims 8 to 10;

12. Signal processing device according to any one of the claims 8 to 11, **characterized in that** the said particles are photons.

13. Radiology apparatus, **characterized in that** it contains at least one device according to any one of claims 8 to 11.

14. Video imaging apparatus, **characterized in that** it contains at least one device according to any one of claims 8 to 11.

15. Fluoroscopy apparatus, **characterized in that** it contains at least one device according to any one of claims 8 to 11.
